Europäisches Patentamt

European Patent Office

Office européen des brevets

(19)

(11) **EP 1 536 539 A1**

(12) **EUROPEAN PATENT APPLICATION**
published in accordance with Art. 158(3) EPC

(43) Date of publication:
**01.06.2005 Bulletin 2005/22**

(51) Int Cl.7: **H02J 7/00**, H01M 10/44

(21) Application number: **03788030.9**

(86) International application number:
**PCT/JP2003/009874**

(22) Date of filing: **04.08.2003**

(87) International publication number:
**WO 2004/017485 (26.02.2004 Gazette 2004/09)**

(84) Designated Contracting States:
**AT BE BG CH CY CZ DE DK EE ES FI FR GB GR
HU IE IT LI LU MC NL PT RO SE SI SK TR**
Designated Extension States:
**AL LT LV MK**

(30) Priority: **15.08.2002 JP 2002237072**

(71) Applicant: **Nisshinbo Industries, Inc.
Chuo-ku, Tokyo 103-8650 (JP)**

(72) Inventors:
• **Sato, Takaya Nisshinbo Industries, Inc.
Chiba-shi, Chiba 267-0056 (JP)**

• **Kobayashi, Yoshiki Nisshinbo Industries, Inc.
Chiba-shi, Chiba 267-0056 (JP)**
• **Nozu, Ryutaro Nisshinbo Industries, Inc.
Chiba-shi, Chiba 267-0056 (JP)**
• **Maruo, Tatsuya Nisshinbo Industries, Inc.
Chiba-shi, Chiba 267-0056 (JP)**
• **Banno, Kimiyo Nisshinbo Industries, Inc.
Chiba-shi, Chiba 267-0056 (JP)**
• **Isobe, Masaaki Nisshinbo Industries, Inc.
Chiba-shi, Chiba 267-0056 (JP)**

(74) Representative: **Thinat, Michel
Cabinet Weinstein,
56 A, rue du Faubourg Saint-Honoré
75008 Paris (FR)**

(54) **RAPID CHARGING BATTERY CHARGING SYSTEM**

(57)    A charging system for a rechargeable battery with a rapid charge capacity. This invention relates to the charging system for the rechargeable battery with a rapid charge capacity which can be recharged at a public place. The charging system comprises a charging equipment for the rapid charge battery, a measurement display unit which measures and displays a charging condition and deterioration of the rapid charge battery, and a fee collection device which collects a charging fee.

FIG. 1

EP 1 536 539 A1

**Description**

FIELD OF THE INVENTION

This invention relates to a charging system for a rapid charge battery used as a power source in various products such as a portable phone, a personal computer, a personal digital assistant (PDA), an electric assist bicycle, an electric automobile, a hybrid automobile, an electric motorcycle, a mini-disc player, a compact disc player, an MPEG3 player, a digital camera, a video camera, a portable radio, a portable television, and more.

BACKGROUND OF THE INVENTION

Traditionally, each rechargeable battery has different characteristics and needs to be paired with suitable charging equipment, which often requires a user to carry the charging equipment with him/she wherever he goes so that he may recharge the rechargeable battery. However, a traditional charging system for a lithium secondary battery takes about 1.5 to 2.5 hours to charge, and a traditional rapid charge system takes about 1 hour to charge. Therefore, the time necessary for charging traditional batteries makes charging outside the home or office an impractical and unrealistic choice. In addition, a particular rechargeable battery must have matching charging equipment, which increases the number of chargers required.

SUMMARY OF INVENTION

It is an object of this invention to provide a charging system for a charge (able) battery that allows for a rapid charge of the battery.
It is another object of this invention to provide technology for making a charging system for a rechargeable battery available at a public place or outside the home or office.
In order to achieve the above stated objects, this invention provides a charging system for a rapid charge battery that is rechargeable in a public area, comprising: a charging equipment for the rapid charge battery; a measurement display unit which measures deterioration and charging level of the rapid charge battery; and a fee collection device that collects a battery charging fee.
This invention further provides a charging system for a rapid charge battery that is rechargeable in a public area, comprising: a charging processor which has charging equipment for the rapid charge battery and a measurement display unit which measures deterioration and charging level of the rapid charge battery; a charging information center which has a data base for storing user information therein; and a charging unit, characterized in that when the user utilizes the charging processor, the charging processor and the charging information center communicate with each other via a communication network.
This invention further provides the charging system above, characterized in that the charging information center has a control unit monitoring and controlling the deterioration of the rapid charge battery and when the deterioration of the rapid charge battery goes below a predetermined level the control unit notifies the user via the charging processor.
This invention further provides the charging system above, characterized in that the rapid charge battery is a nonacqueous electrolyte secondary battery, that comprises positive and negative electrodes having materials that occlude and release a lithium ion and further contains a nonaqueous electrolyte having lithium salt and organic solvent.
This invention further provides a charging system for a rapid charge battery, where if a charging current flows in the rapid charge battery after completing the charging reaction, the rapid charge battery causes migration of electrons only and functions to prevent the electrode active material from transformation.
This invention further provides the above-charging system for a nonaqueous electrolyte secondary battery that involves the electrolyte with a material subject to oxidation at the positive electrode and causes an oxidation reaction different from the lithium release reaction at the positive electrode.
This invention further provides the above-charging system for a nonaqueous electrolyte secondary battery which involves the electrolyte with a material subject to oxidation at the positive electrode that causes an oxidation reaction different from the lithium release reaction at the positive electrode while causing a reduction reaction different from the lithium occlusion reaction at the negative electrode.
This invention further provides the above-charging system, characterized in that the charging equipment of the rapid charge battery is designed such that when charging the electric current values (X ampere, $X \geq 0A$) and the charging time (t seconds, $t \neq 0$ second) with the predetermined P in combination with any of $P_1 (X_1, t_1) \rightarrow P_2 (X_2, t_2) \rightarrow P_3 (X_3, t_3) ... \rightarrow P_n (X_n, t_n) \rightarrow P_{n+1} (X_{n+1}, t_{n+1})$ (here, n = integer of 1 or more) , the electric current values (X ampere) of the continuous charging pattern (P) are different from each other.
This invention also provides the charging system characterized in that the charging equipment uses the pattern in combination with the direct current charging and the constant voltage charging.

BRIEF DESCRIPTION OF DRAWINGS

FIG. 1 is a view illustrating the charging system for the rapid charge battery of this invention;
FIG. 2 is a view illustrating the voltage and battery temperature while the rapid charge battery is being over-charged; and
FIG. 3 is a view illustrating the relation between a charging time and a discharging amount.

Preferred Embodiment of Invention

The preferred embodiments of this invention will be explained next with reference to the accompanied drawings.

<A> Charging System for Rapid Charge Battery

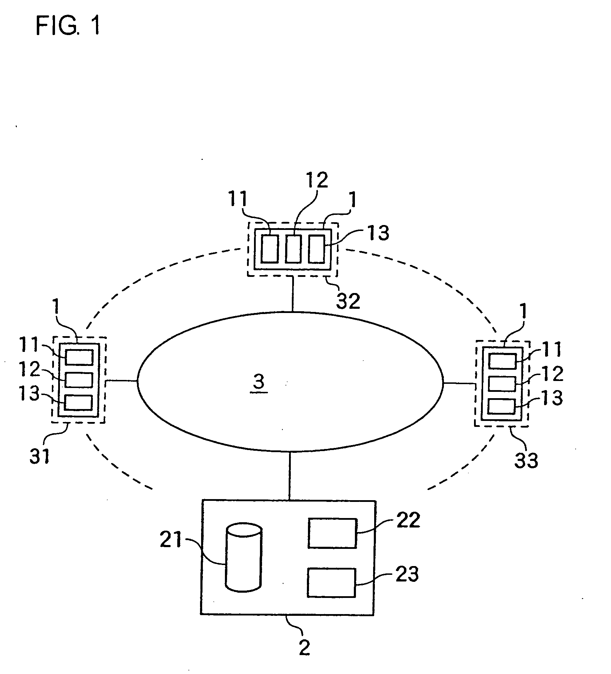

A charging system for a rapid charge battery adds a great feature to a battery with the capability of accomplishing the rapid charge in that a use of this charging system is able to perform the easy rapid charge when the user is away from the home or office.
Generally, the charging system for the rapid charge battery can be installed at public places such as convenience stores, shopping centers, train stations, trains, , cafeterias, entertainment facilities, stadiums (including sports stadiums), restaurants, amusement parks, or any other public place. For example in FIG. 1, the charging system for the rapid charge battery can involve a charging information center 2 which can communicate through a communication network 3 with a charging processor 1 installed at public places such as a cafeteria 31, a station 32, and a train 33.
The rapid charge battery is such that 60% or more, preferably 80% or more, most preferably 90% or more of a battery capacity can be charged within 10 minutes, preferably 5 minutes.
Therefore, if the charging processor 1 is located in various public places, the rapid charge battery of this invention provides a great advantage of the use of the battery without worrying about completely draining the battery while outside the home or office. Further, placing the charging processors 1 in various public places would provide the customer a great service by eliminating the need to purchase one charger for each rechargeable battery with a different standard. Another obvious advantage of this invention is that the user can charge the battery when away from the home or office as he/she wishes and does not have to carry the charger with him/her. As described in this invention, public places include, but are not limited to, places where anyone can use the present invention regardless of payment of fee such as an entrance fee.

<B> Charging Processor

The charging processor 1 is designed to be installed at various public places. The charging processor has a measurement display unit 12 and a fee collection device 13 as desired in addition to a charger 11. The charger can perform rapid charge of 60% or more, preferably 80% or more, most preferably 90% or more of the battery capacity approximately within 10 minutes, most preferably 5 minutes.
The measurement display unit 12 measures a charging condition or a deterioration of the rapid charge battery and can also display to inform the user of the charging condition and the deterioration of the rapid charge battery.
If the deterioration of the battery is below a predetermined level, the charging is stopped. The measurement display unit 12 measures the deterioration while the charger 11 is charging and can measure a quantity of battery electricity prior to and after charging.
The user can know about the quantity of battery electricity (battery charge level) and also can become aware of the deterioration prior to the battery being unusable, and therefore the user at least does not need to worry about the problems of the battery charge level and deterioration.
The user can pay the charging fee for the charging processor 1 through the fee collection device 13. The charging fee may be in proportion to the quantity of electricity used to charge the battery or may be any predetermined price.
Alternatively, the fee collection device 13 may communicate with the charging information center 2 in order to determine whether to charge the particular user by checking the validity of the user registration or types of fee agreement (e.g., month to month or annual).

<C> Charging Information Center

The charging information center 2 communicates with the charging processor 1 through the communication network 3 and, for example, can administer the rapid charge battery and the charging fee of the charging fee of the charging processor 1.

The charging information center 2 can register member users of the rapid charge battery, and the member registration can be filed when the user purchases the equipment or the battery. The charging information center 2 should comprise a database 21 having at least a member name and a type of battery.

For example, the database of TABLE 1 below has the member name, address, phone number, reference number, identification (ID), password, internet protocol (IP) address if IP address is allocated to every device, type and serial number of the battery, deterioration, and a data regarding the fee charging method. When an identical member is using plural rapid charge batteries, the charging information center 2 can administer based on the serial number of the battery.

[TABLE 1]

| Member name | Address | Phone number | Type and Serial number of the battery | Deterioration | Fee charging method |
|---|---|---|---|---|---|
| ... | ... | ... | ... | ... | ... |
| ... | ... | ... | ... | ... | ... |

When the member uses the charging processor 1, the charging processor 1 starts to communicate with the charging information center 2 through the communication network. The control unit 22 receives the type and serial number of the battery, the deterioration level measured at the measurement display unit 12, and records the information in the predetermined location within the database 21. If the deterioration is below the predetermined level, the control unit 22 will notify the measurement display unit 12 as to the degree of deterioration to further notify the user.

Alternatively, the control unit 22 can transmit a trigger signal to the charger 11 so as to stop the charging. As such, controlling of the battery charging can be centralized.

Therefore, the member may feel more secure about the system; allows easy access of the existing battery problems to the service provider and this helps to improve battery technology.

The fee charging device 23 may exchange information with the fee collection device 13 or can be substituted for the fee collection device 13. The fee charging device 23 may have a fee charging system based on various methods such as a per-unit-charge method or a fixed charge method. The per-unit-charge method can automatically charge the fee upon receiving the information from the charging processor 1, such as from a portable phone number, a credit card number, an IP address, or an e-money/electronic money. The fixed charge method can give the fixed charge to the member at a predetermined interval. As necessary, the fee charging device 23 may exchange the data with the fee collection device 13. The charging device 23, for example, may change the charging fee by sending a variable, showing the determined fee, to the fee collection device 13 in order to adjust the charging fee.

<D> Use of Charging Processor

Users of the rapid charge battery and devices that utilize or integrate the rapid charge battery are supposed to charge the rapid charge battery with the charging processor 1 placed in public places. Such rapid charge is available in public places and could be used, for example, when the users ride an electric assist bicycle to go outside and away from their home or office and they can charge the battery while shopping or doing business. The charging processor 1 may be designed to charge a fee by means of the fee collection device 13 right at the charging place or by connecting with the charging information center 2 through the communication network 3 for members to withdraw the amount for the use or the member may utilize the monthly charge from the member's bank account.

<E> Rapid Charge Battery

The rapid charge battery of this invention is not limited to a particular type so long as the rapid charge of the battery is possible. For example, if a charging current flows into the rapid charge battery after completing the charging reaction, the rapid charge battery migrates electrons only but functions to prevent electrode active material itself from changing. The rapid charge battery maintains the battery voltage to be within the predetermined range even after the rapid charge battery is overcharged (over 100% charging rate), and the rapid charge battery maintains the safety of nonaqueous electrolyte secondary battery without a protection network. Therefore, electric energy, furnished by extracting Li from $Li_{0.5}CoO_2$, can be used in another recombinationable reaction to restrict to generate $Li_{<0.3}CoO_2$ and to restrict a runaway reaction of the nonaqueous electrolyte secondary battery. Therefore, a predetermined material may be added to the electrolyte to consume the electric energy at charging due to the electrode oxidation and to restrict to generate $Li_{<0.3}CoO_2$ as a circulatory response system, where reduction of the resulted material of the oxidation occurs at a negative electrode, functions effectively.

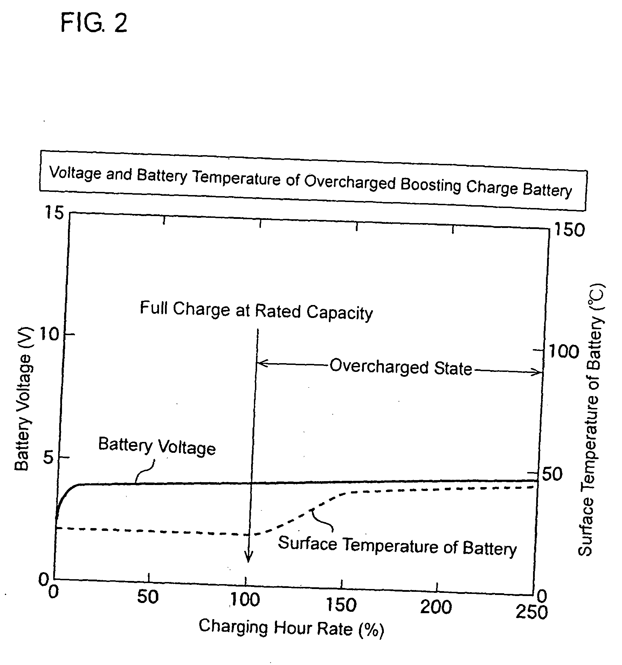

As illustrated in FIG. 2 and referenced in the Japanese Provisional Patent Publication No. 2002-157191, the rapid charge battery can regulate the increase of the battery voltage as well as the surface temperature of the battery even if it is overcharged in consideration of the rated capacity.

In particular, the rapid charge battery may be a nonaqueous electrolyte secondary battery, i.e., the rapid charge battery 1, which comprises positive and negative electrodes having materials that occlude and release a lithium ion and a binder polymer; at least one separator that separates the positive and negative electrodes; and nonaqueous electrolyte having lithium salt and organic solvent, where the nonaqueous electrolyte has material subject to oxidation at the electric potential of 4.1 to 5.2V and where the material causes an oxidation reaction different from lithium release reaction at the positive electrode.

Also, the rapid charge battery may be a nonacqueous electrolyte secondary battery, i.e., the rapid charge battery 2, which comprises positive and negative electrodes having materials that occlude and release a lithium ion and a binder polymer; at least one separator that separates the positive and negative electrodes; and nonaqueous electrolyte having lithium salt and organic solvent. The nonaqueous electrolyte has material subject to oxidation at the electric potential of 4.1 to 5.2V and the material causes an oxidation reaction different from the lithium release reaction at the positive electrode while the material causes a reduction reaction different from lithium occlusion reaction at the negative electrode.

The rapid charge battery, for the above-described two nonacqueous electrolyte secondary batteries, may be such that oxygen and/or carbon dioxide is produced due to the above-described electrode oxidation and that the oxygen and/or carbon dioxide oxidizes minute amounts of lithium metal produced on the negative electrode to $Li_2O$ and/or $Li_2CO_3$ (rapid charge battery 3).

Further, the rapid charge battery, for the above-described two nonacqueous electrolyte secondary batteries, may be such that $Li_2CO_3$ and/or $Li_2O$ is reduced into the lithium ion (rapid charge battery 4).

] The rated capacity of the rapid charge battery is a service capacity when charging with constant current and voltage at 0.2C and discharging with constant voltage at 0.2C to the predetermined discharge final voltage thereafter. For example, for the lithium ion battery using $LiCoO_2$ as the positive electrode and graphite made of graphitizing carbon as the negative electrode, the charging voltage is 4.2V and the discharge final voltage is 2.7V. The oxidation reaction at the positive electrode may occur when the battery voltage ranges between 4.1-5.2V. However, if the oxidation reaction occurs at a battery voltage lower that 4.1V, then sufficient rated capacity may not be obtained. If the oxidation reaction occurs at the battery voltage over 5.2V, the battery runs exothermic and may burst. Therefore, the preferable battery voltage range is between 4.2V and 4.8V.

The oxidation reaction of the positive electrode occurs at 100% charging rate of the rated capacity or more and most preferably the oxidation reaction occurs at 150% charging rate of the rated capacity.

More concretely, the above-described electrode oxidation preferably occurs in the range of 1. 40-1. 60V relative to a reference electrode $AlO_x$. If the electrode oxidation occurs at lower than 1.40V, the above-described electrode oxidation reaction occurs simultaneously or prior to the charging reaction of $LiCoO_2 \rightarrow Li_{0.5}CoO_2$ and therefore the rated capacity may not be obtained. On the other hand, if the electrode oxidation occurs at over 1. 60V, the charging reaction of $Li_{0.5}CoO_2 \rightarrow Li_{<0.5}CoO_2$ occurs prior to the electrode oxidation reaction, thereby loosing reversibility of the positive active material and generating unstable high oxide, possibly causing an overrun of the battery.

Further, if normal hydrogen electrode (SHE) is used as a reference, then it is preferable that the electrode oxidation occurs in the range of 1.05-1.61V relative to SHE under ordinary temperature and normal pressure of 298.15K, 101. 325Pa in one, two, or more types of organic solvent selected from ethylene carbonate, propylene carbonate, vinylene carbonate, and diethyl carbonate.

In this case, if it is lower than 1.05V, the electrode oxidation reaction occurs simultaneously or prior to the charging reaction of $LiCoO_2 \rightarrow Li_{0.5}CoO_2$, and the rated capacity may not be obtained. However, if it is over 1.61V, prior to the electrode oxidation reaction, the charging reaction of $Li_{0.5}CoO_2 \rightarrow Li_{<0.3}CoO_2$ occurs, which looses the reversibility of the positive active material, thereby generating unstable high oxide and may possibly cause a runaway reaction in the battery. In consideration of the above, it is preferable that the electrode oxidation occurs in the range of 1.40-1.60V.

The surface temperature of the battery is not particularly limited unless it causes a problem (this is not clear); however, if the surface temperature is 120 centigrade or more, there is a high possibility that the heat will cause a runaway reaction in the battery. Therefore, the surface temperature of the battery should be lower than 120 centigrade during overcharging and preferably lower than 90 centigrade, and most preferably lower than 70 centigrade.

Further, after the oxidation reaction at the positive electrode, it is preferable to cause a reductive reaction other than an occlusion reaction of the lithium at the negative electrode. There is no particular limit as to the types of oxidation reaction at the positive electrode and the reductive reaction at the negative electrode. For example, oxygen and/or carbon dioxide is generated due to the electrode oxidation, and the oxygen and/or carbon dioxide oxidizes the lithium metal slightly generated on the negative electrode into $Li_2O$ and/or $Li_2CO_3$. Furthermore, by the electric energy supplied during the charge, $Li_2CO_3$ and/or $Li_2O$ is reduced to the metallic lithium and/or lithium ion at the negative electrode.

Lithium is oxidized by oxygen and carbon dioxide is generated by the electrode oxidation without charge-transfer, which is reduced on the electrode (what is reduced on the electrode?), and the material obtained through the electrode reduction is further oxidized on the electrode, thereby establishing a circular reaction to consume the electrical energy supplied during the charge in this circular reaction and effectively preventing an increase of the battery voltage.

On the other hand, even if the battery voltage during the over charge can be prevented if the electrode is deteriorated by such as receiving an irreversible reaction of the electrode during this period of being overcharged, there is a high possibility of loosing the capacity to function as a battery. Therefore, it is preferable to avoid the deterioration of the positive and negative electrodes to the charging rate of L% in the following formula when charging by the charging current at 25 degrees centigrade relative to the theoretical capacity of the positive electrode and at the current value of 1.00C or less.

$$\text{Charging Rate } L(\%) = \text{(Theoretical Capacity)} \times 5 \times \text{(Charging Current Rate C)}^{-0.5} \times 100.$$

When $LiCoO_2$ is used as the positive active material, the thoretical capacity shows the electric capacity equal to $LiCoO_2 \rightarrow 0.5Li^+ + Li_{0.5}CoO_2 + 0.5e^-$.

As a separator for a nonacqueous electrolyte secondary battery, if the battery voltage can be controlled by the electrode reaction in the range of 4.1-5.2V, then it is not required but it is preferable to use the separator that is 40% or more porosity. If the porosity is less than 40%, then the materials in the electrolyte cannot smoothly travel between the positive and negative electrodes, thereby possibly interrupting the circular reaction. Accordingly, the porosity should be as higher as possible as long as it provides sufficient isolation between the positive and negative electrodes and should preferably be 60% or more porosity. Materials for the separator are not limited but it is preferable to have either one of cellulose, polypropylene, polyethylene, and polyester and should preferably be 60% or more porosity.

A nonacqueous electrolyte of a nonacqueous electrolyte secondary battery comprises a lithium salt and an organic solvent. As the lithium salt, no particular limitation exists except that the lithium salt should be able to be used for the nonacqueous electrolyte secondary batteries such as the lithium secondary battery and lithium ion secondary battery. Examples of lithium salt are lithium tetrafluoroborate, lithium hexafluorophosphate, lithiumperchlorate, lithium trifluoromethanesulfonate, sulfonyl imide lithium salt shown in the following formula (1), lithium salt of sulfonylmethide shown in the following formula (2), lithium acetate, lithium trifluoroacetate, lithium benzoate, lithium p-toluenesulfonate, lithium nitrate, lithium bromide, and lithium iodide,lithium tetraphenylborate.

<F> Charging Equipment

The charging equipment of the rapid charge battery is not limited to a particular type but preferably is an equipment that provides efficient rapid charge with high rate small loss, an excellent cycle life of the battery and enhanced safety while being overcharged. That is, the charging equipment of the rapid charge battery performs the predetermined direct current pattern charging configured to differentiate the current value of a continuous charging pattern, so that by setting at least one pattern of the current value to be 1C or greater, the electric energy can effectively be used in chemical reaction, and therefore the coefficient of energy use and the charging efficiency for charging would be increased so as to utilize for the chemical reaction with excellent electric energy efficiency while reducing the charging time required to reach a full charge. Here, while charging, a passive layer of the electrode and electrode active material may be broken, thereby improving the discharging cycle lifetime (as described in detail in the Japanese Patent Application No. 2002-157259.

Charging equipment for the rapid charge battery may be designed such that the electric current values (X ampere) of the consecutive aforementioned charging patterns (P) are different from each other and the rapid charge battery of the nonacqueous electrolyte secondary battery, which is comprised of: positive and negative electrodes involving a material that occludes and/or discharges lithium and binder polymer; at least one separator that separates the positive and negative electrodes; and nonacqueous electrolyte involving lithium salt, is charged in combination using the charging pattern (P) having the electric current value (X ampere and $X \geq 0A$) and the charging time (t seconds, $t \neq 0$ seconds) with $P_1(X_1, t_1) \rightarrow P_2(X_2, t_2) \rightarrow P_3(X_3, t_3)... \rightarrow P_n(X_n, t_n) \rightarrow P_n(X_n, t_n) \rightarrow P_{n+1}(X_{n+1}, t_{n+1})$ (here, n = integer of 1 or more).

Charging equipment for the rapid charge battery may be a charging equipment (charging equipment 2) of the rapid charge battery of the above charging equipment 1, which satisfies the requirements that the electric current value $X_n$ is 1C (1 hour rate) or more and the electric current value $X_{n+1}$ of the charging pattern $P_{n+1}$ ($X_{n+1}$, $t_{n+1}$) (here, every n is integer of 1 or more) is $0 \leq X_{n+1} < X_n$.

The charging equipment of the rapid charge battery may be a charging equipment (charging equipment 3) of the rapid charge battery of the above charging equipment 1 or 2, which satisfies the requirements that the electric current value $X_n$ is 3C (0.33 hour rate) or more and the electric current value $X_{n+1}$ of the charging pattern $P_{n+1}$ ($X_{n+1}$, $t_{n+1}$) (here, every n is an integer of 1 or more) is $0 \leq X_{n+1} < X_n$.

The charging equipment of the rapid charge battery may be a charging equipment (charging equipment 4) of the rapid charge battery of the above charging equipment 1, 2 or 3, characterized in that the charging time $t_n$ of the above charging pattern $P_n(X_n, t_n)$ (here, n is integer of 1 or more) is 1 second or less.

The charging equipment of the rapid charge battery may be a charging equipment (charging equipment 5) of the above-charging equipment 1, 2, 3 or 4, which uses a combination of a direct constant current charging and/or constant voltage charging.

The charging equipment of the rapid charge battery may be a charging equipment (charging equipment 6) of any one of the above-charging equipment 1-5, which comprises positive and negative electrodes having materials that occlude and release a lithium ion and a binder polymer, at least one separator that separates the positive and negative electrodes, and nonaqueous electrolyte having lithium salt and organic solvent, where the nonaqueous electrolyte has material subject to oxidation at the electric potential of 4.1 to 5.2V and the material causes an oxidation reaction different from the lithium release reaction at the positive electrode.

The charging equipment of the rapid charge battery may be a charging equipment (charging equipment 7) of any one of the above-charging equipment 1-6, which comprises positive and negative electrodes having materials that occlude and release a lithium ion and a binder polymer, at least one separator that separates the positive and negative electrodes, and nonaqueous electrolyte having lithium salt and organic solvent, where the nonaqueous electrolyte has a material subject to oxidation at the electric potential of 4.1 to 5.2V and where such material causes an oxidation reaction different from the lithium release reaction at the positive electrode and further causes a reduction reaction different from the lithium occlusion reaction at the negative electrode.

The charging equipment of the rapid charge battery will be explained in greater detail next. The charging equipment for the rapid charge battery is designed such that the electric current values (X ampere) of the consecutive aforementioned charging patterns (P) are different from each other in the case where the rapid charge battery of the nonacqueous electrolyte secondary battery, which is comprised of: positive and negative electrodes involving a material that occludes and/or discharges lithium and binder polymer; at least one separator that separates the positive and negative electrodes; and nonacqueous electrolyte involving lithium salt, is charged in combination of the charging pattern (P) having the electric current value (X ampere and $X \geq 0A$) and the charging time (t seconds, $t \neq 0$ second) with $P_1$ ($X_1$, $t_1$)$\rightarrow$$P_2$ ($X_2$, $t_2$)$\rightarrow$$P_3$ ($X_3$, $t_3$)...$\rightarrow$$P_n(X_n, t_n)$$\rightarrow$$P_{n+1}$ ($X_{n+1}$, $t_{n+1}$) (here, n = integer of 1 or more). That is, the relation of $P_n$, $P_{n+1}$, $P_{n+2}$ and the electric current value X ampere, $X_n$, $X_{n+1}$, $X_{n+2}$ is $X_n \neq X_{n+1}$, $X_{n+1} \neq X_{n+2}$.

On the other hand, $X_n$, $X_{n+2}$, which are not consecutive, may be $X_n = X_{n+2}$ or $X_n \neq X_{n+2}$. Although the amount of electric current value is not limited, when charging is performed at the large electric current value $X_n$ to destroy the immobile layer formed on the electrode and electrode active material, the electrode and the electrode active material receive large amounts of energy and an increase in the temperature (in a microscopic view), and therefore the electric current value $X_{n+1}$ of the next charging pattern is preferably set smaller than $X_n$, i.e., $X_n > X_{n+1}$, to reduce the heat due to the previous charging. The respective charging time $t_n$ of the charging pattern $P_n$ is other than 0 second.

The charging level of the secondary battery may be set as desired between 0 and 100%. The battery capacity must be understood when setting the charging current amount. For example, if the battery capacity is 2Ah, the electric current amount should be sufficient to charge and discharge the battery within 1 hour, i.e., the 2A = electric current value of 1C. Here, the electric current value $X_n$ of the above-charging pattern $P_n$ is preferably 1C or more, and for the purpose of destroying the immobile layer, that may be, for example, formed on the electrode surface and the electrode active material surface to improve the cycle life time of the battery, the electric current value $X_n$ is more preferabley 3C or more and most preferably 5C or more. The maximum charging electric value is not specifically noted but is generally considered to be between 10C-30C.

The charging current value $X_n$ of the charging pattern $P_n$ is preferably 3C or more together with the charging current value $X_{n+1}$ when the charging pattern $P_{n+1}$ is 0A. Accordingly, the charging current value $X_{n+1}$ may be 0A to perform pulsed charging, which prevents an over-increase of the voltage of the nonacqueous electrolyte secondary battery and provides charging with excellent energy efficiency, thereby effectively shortening the time required to fully charge the battery.

Further, when charging with the pulse having the charging current value $X_n$ of the charging pattern $P_n$ is 1C or more and the charging current $X_{n+1}$ of the charging pattern $P_{n+1}$ is 0A, it is preferable that the battery voltage becomes 3.0V at charging and more preferably exceeds 4.2V. In fact, depending upon the setting of the charging current value

$X_n$, the voltage possibly goes up to about 10V but the over-increase of the battery voltage may be controlled by creating the condition where the charging is paused, i.e., $X_{n+1}$ is 0A. Therefore, unlike the conventional charging method, strict control is not necessary to keep the rated full charging voltage in most cases exceeding 4.2V or lower, and the electric current value $X_n$ can appropriately be large enough to provide energy efficient charging, thereby ultimately shortening the time required to fully charge. Intermittent charging among the charging→pausing→charging may efficiently be utilized.

The charging time tn of the above-charging pattern $P_n$ is not limited to what was described above; however, the charging time is preferably 10 seconds or less, more preferably 1.0m-10 seconds, and most preferably 1.0m-1 second. That is, the electric current at charging is set higher to destroy the immobile layer, such as the electrode surface, and then the battery with the destroyed immobile layer is preferably charged, thereby enabling charging of the battery with high energy efficiency. Further, due to the deletion of the immobile layer, the active material is activated, which then increases the cycle life time. However, when destroying the immobile layer, the battery voltage increases, and if the charging is continued it is possible to destroy the active material, electrode, and electrolyte as well as the immobile layer. Although the charging time $t_n$ can be extended while destroying the immobile layer, the destroying strength/effectiveness of the immobile layer is attenuated as time passes, which eliminates the chance of hoping a tremendous effect and also creates a possibility of over-increasing the battery voltage as $t_n$ becomes long, as described above. Accordingly, the charging time $t_n$ of the respective charging pattern $P_n$ is preferably within the above-identified range, and at least $t_n$ should be 1 second or shorter when charging with the large charging current that is sufficient to destroy the immobile layer.

Normally, the secondary battery can be recharged and discharged several hundred times (about 500 times), the above-described charging method for the charging equipment (hereinafter direct current pattern charging method) may be used at every charging cycle for that battery. Further, a combination of the direct current pattern charging method and the conventional constant current charging and/or constant voltage charging may be used.

Combination of the above-described charging methods is not limited to a particular combination. In addition, it is possible to use the method that uses the direct current pattern charging at every predetermined cycle, e.g., basically performing the constant current/voltage charging and then 1 direct current pattern charging at every 50 cycles. This type of combination method is capable of destroying the immobile layer created, such as on the electrode active material, and re-activating the active material when performing the direct current pattern charging, thereby providing effective and efficient charging and also expending the battery cycle life time.

The direct current pattern charging may be combined with the constant current charging and/or constant voltage charging at one charging cycle. For example, the direct current pattern charging is performed up to the predetermined battery capacity and then is switched to the constant current/voltage charging thereafter. Further, the method of combining the respective charging method in one cycle may be performed at every predetermined cycle.

The direct current pattern charging is performed at the initial charging state to destroy the immobile layer created, such as on the electrode active material, and then charging is switched to the constant current/voltage charging. This will simultaneously improve the charging efficiency and extend the battery cycle life. Also, combining the direct current pattern charging with excellent charging efficiency will shorten the charging time for the battery to be fully charged compared to when charging only by the constant current/voltage charging.

The direct current pattern charging is publicly known as a method for charging a nonacqueous electrolyte secondary battery which comprises: positive and negative electrodes having materials that occlude and release a lithium ion and a binder polymer; at least one separator that separates the positive and negative electrodes; and nonaqueous electrolyte having lithium salt and organic solvent. The direct current pattern charging may be used for charging a nonacqueous electrolyte secondary battery where the nonaqueous electrolyte has material subject to oxidation at the electric potential of 4.1 to 5.2V and the material causes an oxidation reaction different from the lithium release reaction at the positive electrode and preferably causes a reduction reaction different from the occlusion release reaction at the negative electrode.

That is, this electrolyte secondary battery does not encourage the over-increase of the battery voltage even if it is charged beyond a full charge. Therefore, when performing the direct current pattern charging the user does not have to worry about the increase of the battery voltage as much as the ordinary secondary battery. This secondary battery can be charged with higher electric current value $X_n(A)$, thereby improving the energy efficiency of charging, realizing a faster charging process than the ordinary secondary battery, and extending the cycle life.

This secondary battery, with excellent over-charging control, prevents an excessive increase of the battery voltage or charging condition because of consuming electric energy during the over-charging due to the oxidation reduction circular reaction of the material which is added in the electrolyte and is subject to the electrode oxidation.

However, the oxidation reduction circular reaction at the negative and positive electrodes may radically decrease the reaction activity when the immobile layer is created, such as on the electrode and electrode active material.

For example, if the battery is temporarily left in an almost fully charged condition and then is recharged and overcharged, the oxidation reduction circular reaction does not progress smoothly and the battery voltage increases within the over-charged state.

This problem is due to the fact that the oxidation reduction circular reaction does not progress smoothly because of the immobile layer, which can be resolved by using the direct current pattern charging of this invention.

That is, in order to recharge the secondary battery with an excellent over-charge control after charging up to or over a fully charged condition, e.g., about 60% charging rate or more and about 3.8V of the battery voltage or more, the secondary battery is left for a predetermined period, e.g., about 15-30 hours, it is preferable, for safety reasons, that the direct current pattern charging is used at least at the initial stage of recharging.

In the nonacqueous electrolyte secondary battery with excellent over-charging control, at least the electrode oxidation reaction should occur at 100% charging rate or more of the rated capacity. On the other hand, it is preferable that the electrode oxidation reaction occurs at 150% charging rate or more because the electrode oxidation reaction should be caused without losing the reversibility of the active material while keeping the rated capacity of the battery

Embodiments of the rapid charge battery will be explained next.

<A> Composition of Thermoplastic Polyurethane Resin

64.34 parts by weight of pre-thermal dehydrated polycaprolactonediol (e.g., PRACCEL 220N by Daicel Chemical Industries, Ltd.) and 28.57 parts by weight of 4, 4' - diphenylmethanediisocyanate are added in a reactor with a mixer, a thermometer, and a cooling tube, which are mixed for about 2 hours at 120□ under a nitrogen gas stream. After the mixing process, 7.09 parts by weight of 1, 4 - butanediol is added therein and the mixture is similarly reacted at 120□ under a nitrogen gas stream. The reaction is stopped when the reaction progresses and the reactants become a rubber like substance. Then, the reactants are removed from the reactor to be heated at 100□ for about 12 hours until the infrared absorption spectrum shows extinction of the peaks of absorption of the isocyanate group, thereby obtaining a solid polyurethane resin.

Average molecular weight of the resulted polyurethane resin is $1.71 \times 10^5$ (Mw). Polyurethane 8 weight parts dissolves in N - methyl - 2 - pyrrolidone of 92 weight parts to obtain polyurethane resin solution.

<B> Composition of Polyvinylalcohol Derivative

(Composition 2)

Polyvinylalcohol 3 weight parts (average polymerization degree of 500, vinylalcohol fraction = 98% or higher), 1, 4 - dioxane 20 weight parts, and acrylonitrile 14 weight parts are placed in the reactor with blades, which are mixed for 10 hours at 25□, concurrently and gradually adding solution of sodium hydroxide 0.16 weight parts dissolved in water 1 weight parts therein.

Next, the mixture is neutralized with an ion-exchange resin (Amberlite IRC-76 by Organo Corporation). After filtering the ion-exchange resin out, acetone of 50 weight parts is added to the solution in order to filter insoluble matters. The acetone solution is placed in a dialysis membrane tube to be dialyzed with living water. Polymer deposited in the dialysis membrane tube is gathered and dissolved with the acetone again to be filtered. Then, the acetone is vaporized to obtain cyanoethyl PVA derivative of composition example 1.

No absorption of the hydroxyl group is found by infrared absorption spectrum in the resultant polymer derivative, and the hydroxyl group is completely sequestered by cyanoethyl group (sequestering rate of 100%).

The resulted PVA polymer 3 weight parts is mixed with dioxane 20 weight parts and acrylonitrile 14 weight parts. Sodium hydroxide solution of water 1 weight part with dissolved sodium hydroxide 0.16 weight part is added to the above-mixture of PVA polymer, dioxane and acrylonitrile, all of which are mixed/stirred for 10 hours at 25□.

Next, the mixture is neutralized with ion-exchange resin (Amberlite IRC-76 by Organo Corporation). After filtering the ion-exchange resin out, acetone of 50 weight parts is added to the solution in order to filter insoluble matters. The acetone solution is placed in a dialysis membrane tube to be dialyzed with living water. Polymer deposited in the dialysis membrane tube is gathered and dissolved with the acetone again to be filtered. Then, the acetone is vaporized to obtain cyanoethyl PVA derivative.

No hydroxyl group absorption is found by infrared absorption spectrum in the resultant polymer derivative, and the hydroxyl group is completely sequestered by cyanoethyl group (sequestering rate of 100%).

<C> Forming Positive Electrode

A positive electrode active material, i.e., $LiCoO_2$ by Seido Kagaku Kabushiki Kaisha, a conductive material, i.e., ketjenblack EC by Lion Corporation, polyvinylidene fluoride (PVDF1300) by Kureha Chemical Industries, Company Ltd., and polyurethane (PU) of the composition example 1 are mixed in proportion to mass compounding ratio of 100.0 : 4.35 : 4.13 : 2. 72 respectively, which dissolve in 1 - methyl - 2 - pyrolidone (NMP, mass ratio 56.74 relative to $LiCoO_2$

100) (Wako Pure Chemical Industries, Ltd.) to disperse, mix and slurry the same. The slurry is applied on the aluminum sheet (0. 020mm thickness by Nihon Foil Manufacturing Company Ltd.) to be dried, rolled, and cut in 50.0mm (inner coated portion : 40.0mm) x 20.0mm and 50.0 x 270.0mm to obtain the positive electrode. The electrode with the mass ratio 0.280g and thickness 0.080mm is selected for this use.

Formation of Negative Electrode

A negative electrode active material, i.e., MCMB (by Osaka Gas Chemicals Company Ltd.) and polyvinylidene fluoride (PVDF900) by Kureha Chemical Industries, Company Ltd., are mixed in proportion to mass compounding ratio of 100.0 : 8.70 respectively, which dissolves in NMP (mass ratio 121. 7 relative to MCMB 100) to disperse, mix and slurry the same. The slurry is applied on the copper foil (0.010mm thickness by Nihon Foil Manufacturing Company Ltd.) to be dried, rolled, and cut in 50.0mm (inner coated portion : 40.0mm) x 20.0mm to obtain the negative electrode.

Formation of Electrode Group

Cellulose separator (0.035mm thickness of TF40-35 by Nippon Kodoshi Corporation) is cut into 2 pieces of 54. 0 x 22. Omm, which are sandwiched by the above-mentioned two pieces of positive electrode and two pieces of negative electrode to form the electrode group.

Formation of Electrolytic Solution

1.0M solution of $LiPF_6$ (ethylenecarbonate or EC : diethylenecarbonate or DEC : propylenecarbonate or PC : vinylenecarbonate or VC = 100.0 : 157.1 : 28.57 : 2.857, mass ratio) are arranged from $L_iPF_6$ (by Kishida Chemical Company Ltd., 1.0M ethylene carbonate/diethylcarbonate = 1/1 solution). Then, relative to the mass 100 of EC within the above solution, polyvinylalcohol derivative of the composition example 2 of 1.00, NK ester M-20G (monomethacrylate), NK ester 9G (dimetacrylate), NK ester TMPT (trimethacrylate) (all of which are manufactured by Shin-Nakamura Chemical Corporation and are in the proportion of 9. 358, 13. 09, 1.100 respectively), and 2, 2' - azobis (2, 4 - dimethylvaleronitrile by Wako Pure Chemical Industries, Ltd.) are added, stirred, and mixed to obtain nonacqueous electrolyte.

Forming Rapid Charge Battery

After measuring the outside diameter length of the above-electrode group and injecting the above-electrolytic solution of 100.0 vol%, i.e., capacity approximately equal to the calculated volume, the pressure therein is reduced to about 76 Torr and laminated (packaged) to obtain the nonacqueous electrolyte secondary battery.

Relative to this secondary battery, the battery capacity is the capacity of the above-positive electrode active material determined from the theoretical value 137mAh/g of the electric capacity relative to x = 0.5 in Faraday reaction of the positive electrode active material of the battery, i.e., $LiCoO_2 \rightarrow Li_xCoO_2 + (1 - x) Li^+ + (1 - x)$ e-, which is regarded as 100% charged condition (about 36.0mAh).

After charging to 1.50V with the electric current ratio of 0.01C at initial charging relative to the rapid charge battery, and further charging to 3.20V with the electric current ratio of 0.05C, the rapid charge battery is aged for a period of 2 hours at 5.5□ and further for 30 minutes at 800, to gall the electrolyte.

Next, an initial condition of the battery sample (SOC = 0%) is set at the point when performing 3 cycles, each comprising of charging with constant current-constant voltage at the programmed voltage 4.20V and current termination 0.10C, pausing for 1 hour, and discharging at a constant current with 3.0V termination at 1.00C, and pausing for 1 hour, and further performing constant current discharge at the electric current ratio 0.20C up to 2.75V.

Embodiments of charging the battery will be explained next.

Method of Charging

The secondary battery formed in the above-embodiments is charged with the later described pattern so that the charging ratio from 0% goes up to about 50%, 70%, and 90% relative to the rated capacity (36.0mAh). Then, the charging is paused for 1 hour and the constant electric current discharge is performed at the electric current ratio 0.2C (7.2mA) to 2.75V. The quantity of electricity charged here is calculated.

Method of Charging in First Embodiment

The secondary battery is charged for about 50%, 70% and 90% in a continuous pattern of Pa : $P_1$ [1627.2mA (45.2C), 4.0m sec.] $\rightarrow P_2$ [0A (0C), 12.0m sec.] $\rightarrow P_1 \rightarrow P_2 \rightarrow \cdot \cdot \cdot$. Charging time up to 90% is about 300 seconds (5 minutes).

Method of Charging in the Second Embodiment

The secondary battery is charged with an electricity quantity of 57.8% in a pattern of Pa : $P_1$ [1627.2mA (45.2C), 4.0m sec.] $\rightarrow P_2$ [0A (0C), 12.0m sec.] $\rightarrow P_1 \rightarrow P_2 \rightarrow \cdots$ and is charged with quantity of electricity 23.7% in a pattern of Pb : $P_3$ [1548mA (43C), 2.0m sec. ] $\rightarrow P_4$ [0A (0C), 8.0m sec. ] $\rightarrow P_3 \rightarrow P_4 \rightarrow \cdots$ . Then, the secondary battery is charged with the quantity of electricity 9.0% in a pattern of Pc: $P_5$ [1407.6mA (39.1C), 1.0m sec. ] $\rightarrow P_6$ [0A (0C), 5.0m sec.] $\rightarrow P_5 \rightarrow P_6 \rightarrow \cdots$ . In total, the quantity of electricity 90.5% is charged, which requires 310 seconds (5 minutes and 10 seconds).

<D> Discharging Characteristics

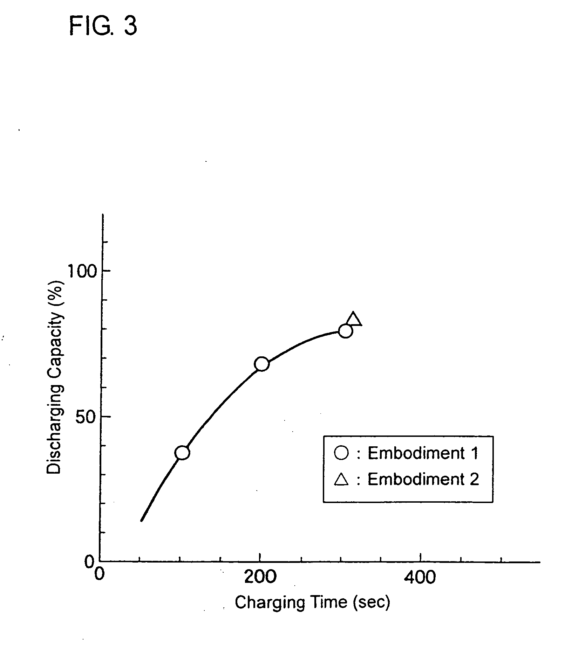

Constant electric current discharge is performed at current ratio 0.2C (7.2mA) up to 2.75V on the secondary battery charged at the first and second embodiments, and the quantity of electricity discharged is determined. FIG. 3 shows the result of the calculation. Axis of abscissa shows time (second) required for charging and axis of ordinate shows percentage of discharging capacity relative to the rated capacity of the battery. As shown from the result of FIG. 3, in the first embodiment, 127 seconds are required to charge about 50% of the battery capacity and the discharging capacity is 47%. Further, 200 seconds are required to charge about 70% of the battery capacity and the discharging capacity is 69%. Yet further, 300 seconds is required to charge about 90% of the battery capacity and the discharging capacity is 80%.
In the second embodiment, 310 seconds are required to charge about 90.5% of the battery capacity and the discharging capacity is 84%.

Result of Charging

The embodiments utilize the direct current pattern charging where the battery is charged with a high electric current ratio of 45C to 30C and the charging is paused. Therefore, the charging ratio is increased, which makes it possible to provide rapid charge of the battery capacity 90% within about 5 minutes.

Advantages of the Invention

This invention has the following advantages.
This invention provides a charging system for a rapid charge battery.
This invention provides a technology for anyone to charge a rechargeable battery in a public area.

**Claims**

1. A charging system for a rapid charge battery which is capable of operating in a public place, comprising:

   a charging equipment for said rapid charge battery;
   a measurement display unit which measures and displays deterioration and charging level of said rapid charge battery;
   a fee collection device which collects a battery charging fee.

2. A charging system for a rapid charge battery which is capable of operating in a public place, comprising:

   a charging processor which has a charging equipment for said rapid charge battery and a measurement display unit which measures deterioration and charging level of said rapid charge battery; and
   a charging information center which has a data base to store user information therein and a charging unit, **characterized in that**
   when the user utilizes said charging processor, said charging processor and said charging information center communicate with each other via a communication network.

3. The charging system for the rapid charge battery of Claim 2, **characterized in that**
   said charging information center has a control unit monitoring and controlling the deterioration of the rapid charge battery; and

said control unit notifies the user via said charging processor when the deterioration of the rapid charge battery goes below a predetermined level.

EP 1 536 539 A1

FIG. 1

13

## FIG. 2

Voltage and Battery Temperature of Overcharged Boosting Charge Battery

FIG. 3

## INTERNATIONAL SEARCH REPORT

| International application No. |
|---|
| PCT/JP03/09874 |

**A. CLASSIFICATION OF SUBJECT MATTER**
Int.Cl$^7$ H02J7/00, H01M10/44

According to International Patent Classification (IPC) or to both national classification and IPC

**B. FIELDS SEARCHED**

Minimum documentation searched (classification system followed by classification symbols)
Int.Cl$^7$ H02J7/00, H01M10/44

Documentation searched other than minimum documentation to the extent that such documents are included in the fields searched
| | | | |
|---|---|---|---|
| Jitsuyo Shinan Koho | 1926–1996 | Jitsuyo Shinan Toroku Koho | 1996–2003 |
| Kokai Jitsuyo Shinan Koho | 1971–2003 | Toroku Jitsuyo Shinan Koho | 1994–2003 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 6-150920 A (Matsushita Electric Industrial Co., Ltd.), 31 May, 1994 (31.05.94), Full text (Family: none) | 1–3 |
| Y | WO 96/015020 A1 (VATTENFALL AB), 18 January, 1996 (18.01.96), Full text; all drawings & US 5903064 A & EP 769218 B1 & JP 10-502517 A | 1–3 |
| Y | JP 11-86058 A (Nitsuko Corp.), 30 March, 1999 (30.03.99), Full text; all drawings. (Family: none) | 1–3 |

| ☒ Further documents are listed in the continuation of Box C. | ☐ See patent family annex. |
|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier document but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 21 August, 2003 (21.08.03) | 02 September, 2003 (02.09.03) |

| Name and mailing address of the ISA/ | Authorized officer |
|---|---|
| Japanese Patent Office | |
| Facsimile No. | Telephone No. |

Form PCT/ISA/210 (second sheet) (July 1998)

**EP 1 536 539 A1**

<table>
<tr><td colspan="2" align="center">**INTERNATIONAL SEARCH REPORT**</td><td>International application No.<br>PCT/JP03/09874</td></tr>
</table>

C (Continuation). DOCUMENTS CONSIDERED TO BE RELEVANT

| Category* | Citation of document, with indication, where appropriate, of the relevant passages | Relevant to claim No. |
|---|---|---|
| Y | WO 01/65627 A1 (Matsushita Electric Industrial Co., Ltd.),<br>07 September, 2001 (07.09.01),<br>Full text; all drawings<br>& EP 1261064 A1      & US 2003/137277 A1 | 1-3 |

Form PCT/ISA/210 (continuation of second sheet) (July 1998)